# DEMANDE DE BREVET EUROPEEN

(11) **EP 4 561 295 A1**
(43) Date de publication de la demande: **28.05.2025**
(21) Numéro de dépôt: 24214630.6
(22) Date de dépôt: 21.11.2024
(51) Int. Cl.: H10D 48/32, H10D 48/01, H10D 30/01, H10D 30/40, H10D 62/10, H10D 62/81, H10D 64/27, H10D 48/00, B82Y 10/00

(54) **MATRICE BIDIMENSIONNELLE DE DISPOSITIFS QUANTIQUES COMPORTANT DES DÉTECTEURS DE CHARGE INTÉGRÉS ET MÉTHODE DE FABRICATION**

(30) Priorité: 21.11.2023 FR 2312792
(71) Demandeur: Commissariat à l'Energie Atomique et aux Energies Alternatives, 75015 Paris (FR)
(72) Inventeur: BERTRAND, Benoit, 38054 GRENOBLE CEDEX 09 (FR)
(74) Mandataire: Cabinet Camus Lebkiri

(57) **Abrégé**

Un aspect de l'invention concerne un dispositif quantique (100) comprenant :
- Une couche semiconductrice (110) adaptée pour former une matrice bidimensionnelle (115) de boites quantiques (1151), la couche semiconductrice (110) présentant une face avant (110a),
- un diélectrique (120), disposé sur la face avant (110a) de la couche semiconductrice (110),
- Des premières grilles (131) et des deuxièmes grilles (132) pour contrôler les boîtes quantiques (1151), les premières grilles (131) et les deuxièmes grilles (132) s'étendant directement sur le diélectrique (120), chaque deuxième grille (132) croisant les premières grilles (131),
- Des détecteurs de charges (140), chaque détecteur de charge (140) comprenant un ilot conducteur (141) et un réservoir de charge (142),
l'ilot conducteur (141) de chaque détecteur de charge (140) étant formé entre deux premières grilles (131) adjacentes et directement sur le diélectrique (120).

## Description

### DOMAINE TECHNIQUE DE L'INVENTION

Le domaine technique de l'invention est celui de l'électronique quantique et plus particulièrement des dispositifs électroniques quantiques et de la fabrication de ces derniers.

### ARRIERE-PLAN TECHNOLOGIQUE DE L'INVENTION

L'utilisation d'états quantiques à deux niveaux mesurables comme vecteur d'information, également appelés "qubits" pour "quantum bits" en anglais, et des lois de la mécanique quantique (superposition, intrication, mesure) offre la possibilité de développer des algorithmes quantiques surpassant en performances certaines classes d'algorithmes classiques. Pour les implémenter, des milliers de qubits sont requis. Enfin, trois types d'opérations doivent pouvoir être effectuées sur les qubits : l'initialisation dans un état connu, la manipulation (portes logiques sur un ou plusieurs qubits), et la lecture de ces qubits.

Les technologies semi-conductrices à même de permettre la manipulation de qubits, comprennent des îlots, également appelés boîtes quantiques, réalisés dans des structures de confinement de tailles nanométriques définies par exemple de manière électrostatique au sein d'une couche semiconductrice. Les boites quantiques assurent le confinement de charges élémentaires, électrons ou trous, et l'information quantique est, par exemple, codée sur le spin de ces particules.

Pour qu'une boite quantique soit fonctionnelle, c'est-à-dire pour qu'elle puisse être initialisée, manipulée et lue, elle doit être couplée à une électronique de lecture capable de déterminer le nombre de charge dans la boite quantique.

L'utilisation de dispositifs supplémentaires couplés à une électronique de lecture, tels que des détecteurs de charge mesurés en courant ou en réflectométrie, permet de réaliser une détection du nombre de charge plus efficace que des méthodes de détection in-situ.

Les transistors à un électron SET (acronyme de « single Electron Transistor » en anglais) font partie des détecteurs de charge les plus efficaces.

En général, un SET comprend un point quantique, ou îlot, deux réservoirs de charge, aussi appelés drain et source, et un contact de grille.

L'ilot est relié à chacun des réservoirs par au moins une jonction tunnel, ou couplage tunnel, définie électro-statiquement.

Les réservoirs de charge (drain et source) sont considérés comme des matériaux métalliques massifs dont les électrons obéissent à la statistique de Fermi-Dirac, et l'îlot est par exemple un grain de métal dont la taille est de quelques nanomètres. Le contact de grille est typiquement une couche de matériau diélectrique. La jonction tunnel est réalisée par une autre couche de matériau diélectrique, dite jonction tunnel, agencée de sorte à séparer l'ilot des réservoirs de charge et du contact de grille.

Une ou plusieurs électrodes sont par ailleurs connectées aux réservoirs de charge et au contact de grille pour appliquer une tension sur ces éléments.

Le fonctionnement des SET repose sur un couplage capacitif avec la boite quantique, une fluctuation du nombre de charges de la boite quantique modifiant par exemple la conduction du SET et pouvant donc être mesurée.

Cette détection, ou lecture, de la charge résultante est généralement effectuée en courant (en transport) ou par réflectométrie avec l'utilisation d'un résonateur LC.

Lorsque le SET est lu en courant, son drain et sa source sont polarisés indépendamment l'un de l'autre. Dit autrement, deux réservoirs de charge indépendants (source et drain) sont nécessaires.

Lorsque le SET est lu par réflectométrie, il n'est pas nécessaire qu'il soit traversé par un courant statique. Son drain et sa source sont donc polarisables au même potentiel, et un seul réservoir de charge (drain ou source) est suffisant. Dans ce cas, le SET, qui n'est plus tout-à-fait équivalent à un transistor, est aussi appelé « boite quantique à réservoir unique » ou SLQD (pour « Single Lead Quantum Dot » selon l'acronyme d'origine anglosaxonne couramment utilisé).

L'intégration des SET au plus près des qubits serait avantageuse pour améliorer la sensibilité de la détection, et préserver l'espace nécessaire à l'implémentation des fonctionnalités de contrôle des qubits.

Or les SETs, sont coûteux en termes d'encombrement du fait du nombre d'éléments qui les constituent. Leur intégration dans le plan des qubits réduit le nombre de qubits pouvant y être intégrés par unité de surface et nécessite des interactions à plus longue portée entre qubits voisins.

Pour remédier à cette difficulté, il est proposé d'intégrer les SETs en périphérie de la matrice de qubits. L'inconvénient est que la taille de cette matrice doit être réduite à quelques boites quantiques par côté pour permettre de lire les qubits disposés au centre de la matrice.

Il est par ailleurs proposé d'intégrer et de connecter les détecteurs de charges dans des plans différents du plan comprenant les boîtes quantiques. On parle dans ce cas de circuits à architecture non-planaire, dite également "3D" pour "à 3 dimensions".

La demande de brevet FR 3 066 297 propose ainsi un circuit électronique quantique à contrôle parallèle comprenant une couche semiconductrice recevant une matrice de qubits, un réseau d'électrodes disposé de chaque côté de cette couche semiconductrice, et un plan empilé sur la couche semiconductrice comprenant une matrice de détecteurs de charge.

Cette solution présente l'avantage que chaque détecteur de charge est disposé à proximité d'un qubit, cela quel que soit le qubit considéré dans la matrice.

Toutefois, l'architecture de ce circuit est particulièrement complexe, notamment du fait de la forte densité de vias et d'interconnexions. De ce fait, certaines étapes de fabrication peuvent être difficiles à réaliser.

Ainsi, il n'existe actuellement pas de solution satisfaisante pour intégrer des SETs dans des circuits électroniques quantiques 2D de haute densité.

Il reste ainsi un besoin d'une solution d'intégration de détecteurs de charge mesurés en réflectométrie dans des matrices de boites quantiques bidimensionnelles, qui permette un bon couplage capacitif entre ces détecteurs de charge et ces boites quantiques, tout en étant simple à mettre en oeuvre.

### RESUME DE L'INVENTION

La présente invention offre une solution aux problèmes évoqués précédemment en permettant de réduire, sur la puce électronique, l'encombrement et la complexité de détecteurs de charge lus en réflectométrie.

Plus particulièrement, un premier aspect de l'invention propose un dispositif quantique comprenant :
- Une couche semiconductrice adaptée pour former une matrice bidimensionnelle de boites quantiques, la couche semiconductrice présentant une face avant,
- Un diélectrique, disposé sur la face avant de la couche semiconductrice,
- Des premières grilles et des deuxièmes grilles pour contrôler les boîtes quantiques, les premières grilles et les deuxièmes grilles s'étendant directement sur le diélectrique, chaque deuxième grille croisant les premières grilles, les premières et deuxièmes grilles définissant un réseau de mailles bidimensionnelles, chaque maille étant en regard d'une boite quantique,
- Des détecteurs de charges, chaque détecteur de charge comprenant un réservoir de charge conducteur et un îlot conducteur,
l'ilot conducteur de chaque détecteur de charge étant formé au niveau d'une maille bidimensionnelle, entre deux premières grilles adjacentes et directement sur le diélectrique.

Ainsi, de manière avantageuse selon l'invention, l'îlot conducteur de chaque détecteur de charge est formé au même niveau que celui des premières et deuxièmes grilles (l'expression « même niveau » signifie ici dans le niveau compris entre une face inférieure des premières grilles et une face supérieure des deuxièmes grilles). Cela permet d'obtenir un dispositif quantique compact (en termes de hauteur). Cela permet, aussi, d'obtenir un dispositif quantique qui n'utilise qu'un seul substrat semiconducteur et dont la fabrication ne fait pas appel à des étapes de collage.

De plus, grâce à l'îlot conducteur qui est posé sur le diélectrique dans une maille bidimensionnelle, il y a un bon couplage capacitif entre la boite quantique formée à l'aplomb de la maille bidimensionnelle et les boites quantiques voisines. Cette proximité améliore la sensibilité de la détection du dispositif quantique. Il convient d'ajouter que le fait de former les îlots conducteurs entre des premières grilles offre l'avantage de pouvoir utiliser ces premières grilles comme repère d'alignement au moment des étapes de fabrication des îlots conducteurs. Dit autrement, les premières grilles permettent d'« auto-aligner» les îlots. Cet auto-alignement facilite ces étapes de fabrication.

Le dispositif quantique selon l'invention offre ainsi une solution d'intégration compatible avec les procédés de fabrication industriels et l'intégration de boites quantiques à large échelle, tout en permettant la proximité requise entre les détecteurs de charge lus en courant et les boites quantiques.

Outre les caractéristiques qui viennent d'être évoquées dans le paragraphe précédent, le dispositif quantique selon le premier aspect de l'invention peut présenter une ou plusieurs caractéristiques complémentaires parmi les suivantes, considérées individuellement ou selon toutes les combinaisons techniquement possibles :
- Chaque détecteur de charge comprend un terminal de grille, ledit terminal de grille étant formé par une couche barrière recouvrant l'îlot conducteur correspondant au détecteur de charge.
- l'ilot conducteur de chaque détecteur de charge est formé dans une grille de contrôle des boites quantiques distincte des premières grilles, ladite grille croisant les premières grilles et s'étendant directement sur le diélectrique, ladite grille présentant des renfoncements recouverts d'une couche électriquement isolante, les renfoncements isolants étant disposés aux croisements de ladite grille avec les premières grilles, chaque renfoncement isolant abritant une première grille, les renfoncements isolants définissant dans ladite grille une pluralité de régions conductrices inférieures s'étendant directement sur le diélectrique, et une région conductrice supérieure continue.
- ladite grille est une des deuxièmes grilles.
- Alternativement, ladite grille est une troisième grille d'un ensemble de troisièmes grilles destinées à contrôler le potentiel chimique des boites quantiques, chaque troisième grille étant disposée à l'aplomb des boites quantiques formées le long d'une colonne ou d'une diagonale de la matrice de boites quantiques.
- Quelle que soit ladite grille, ladite grille présente une structure interne d'un premier type comprenant :
   - une région conductrice inférieure sur deux prolongeant la région conductrice supérieure vers le diélectrique et définit une région conductrice inférieure complémentaire,
   - la région conductrice inférieure complémentaire recouverte d'une couche barrière inférieure, appelée couche tunnel, la couche tunnel étant disposée sur les renfoncements isolants adjacents à la région conductrice inférieure complémentaire,
   - un motif diélectrique formant une couche barrière supérieure s'étendant à travers la région conductrice supérieure de la couche tunnel jusqu'à la face supérieure de ladite grille, le motif diélectrique étant enrobé par la région conductrice supérieure et disposé à l'aplomb d'une partie au moins de la région conductrice inférieure complémentaire.
- une deuxième grille sur deux, ou une troisième grille sur deux, peut alors présenter la structure interne du premier type.
- les ilots conducteurs sont disposés alors en quinconce les uns par rapport aux autres.
- Alternativement, chaque deuxième grille, ou chaque troisième grille, peut présenter la structure interne du premier type.
- Alternativement, ladite grille présente une structure interne d'un deuxième type dans lequel :
   - Toutes les régions conductrices inférieures de ladite grille sont recouvertes d'une couche tunnel, la couche tunnel étant continue et disposée sur les renfoncements de ladite grille,
   - Chaque région conductrice inférieure est surmontée d'un motif diélectrique, chaque motif diélectrique formant avec la couche tunnel une couche barrière, chaque motif diélectrique traversant
   la région conductrice supérieure de la couche tunnel disposée sur la région conductrice inférieure associée jusqu'à la face supérieure de ladite grille, le motif diélectrique étant enrobé par la région conductrice supérieure et disposé à l'aplomb d'une partie au moins de la région conductrice inférieure associée.
- une deuxième grille sur deux, ou une troisième grille sur deux, peut alors présenter la structure interne du deuxième type.
- Alternativement, chaque deuxième grille, ou chaque troisième grille, peut présenter la structure interne du deuxième type.
- la région supérieure de ladite grille peut être couplée à une source de tension pour adresser les sources des détecteurs de charges formés dans ladite grille.
- Chaque motif diélectrique peut être prolongé, au-dessus de ladite grille, par un via conducteur, dit via de grille.
- Le dispositif quantique peut comprendre des lignes de contrôle des détecteurs de charge, chaque ligne étant couplée d'une part aux vias de grille disposés sur une même ligne de la matrice de boite quantiques et, d'autre part, à une source de tension.
- Le dispositif quantique peut comprendre des lignes de métallisation, dites ligne de lecture des détecteurs de charge, chaque ligne de lecture étant couplée, d'une part à la région supérieure d'une grille définissant des ilots conducteurs, et d'autre part à un circuit de lecture, ledit circuit de lecture comprenant une inductance et une capacité formant un circuit résonant dont la fréquence de résonance dépend de l'impédance des détecteurs de charge, permettant des mesures en réflectométrie.
- Chaque ligne de lecture couple des portions conductrices situées sur une même ligne de la matrice de boites quantiques, ou couple des portions conductrices situées sur une même diagonale de la matrice de boites quantiques.
- La couche semiconductrice comprend des trous pour former les boites quantiques,
- Les trous sont disposés à l'aplomb des mailles du réseau de mailles bidimensionnelles défini par les premières et deuxièmes grilles.
- L'ilot de chaque détecteur de charges est situé dans un même plan horizontal que les premières lignes de grilles, et le réservoir de charges de chaque détecteur de charges est situé dans un même plan horizontal qu'une région conductrice supérieure des deuxièmes lignes de grilles.

Un deuxième aspect de l'invention concerne un procédé de fabrication d'un dispositif quantique comprenant des détecteurs de charge, chaque détecteur de charge comprenant un îlot conducteur et un réservoir de charge, le procédé comprenant les étapes suivantes :
- Fourniture d'une couche semiconductrice adaptée pour former une matrice bidimensionnelle de boites quantiques, ladite couche semiconductrice présentant une face avant, ladite couche semiconductrice comprenant un diélectrique disposé sur la face avant et des premières grilles pour contrôler les boites quantiques, les premières grilles s'étendant directement sur le diélectrique,
- Enrobage des flancs et de la face supérieure de chaque première grille pour loger chaque première grille sous un renfoncement isolant,
- Définition des îlots conducteurs à partir des premières grilles enrobées, chaque ilot conducteur s'étendant entre deux premières grilles adjacentes et directement sur le diélectrique,
- Formation, à partir des îlots conducteurs définis, de deuxièmes grilles pour contrôler, avec les premières grilles, les boites quantiques, chaque deuxième grille s'étendant directement sur le diélectrique et croisant les premières grilles, les premières et deuxièmes grilles formant un réseau de mailles bidimensionnelles sur le diélectrique.

De préférence, l'étape de définition des îlots conducteurs peut comprendre les sous-étapes suivantes :
- Remplissage avec un matériau conducteur des espaces du diélectrique délimités par deux premières grilles adjacentes enrobées, le remplissage s'arrêtant à la hauteur des renfoncements isolants,
- Formation d'une couche barrière sur toute la surface obtenue après le remplissage,
- Structuration de la couche barrière pour former des bandes barrières orientées avec un angle prédéterminé par rapport aux premières grilles.

De préférence, l'angle prédéterminé est tel que les bandes barrières sont orientées à 45° par rapport à la direction des premières grilles, les bandes barrières s'étendant, dans la direction perpendiculaire aux premières grilles, sur quatre bandes conductrices adjacentes.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre une représentation schématique en vue de dessus d'un dispositif quantique selon un premier mode de réalisation de l'invention,
- La figure 2 montre une représentation schématique en vue de coupe du dispositif quantique représenté sur la figure 1,
- La figure 3 montre une représentation schématique d'une partie du dispositif quantique représenté sur la figure 2,
- La figure 4 montre une représentation schématique en vue en perspective d'une partie du dispositif quantique représenté sur la figure 1,
- La figure 5 montre une représentation schématique en vue de dessus d'un dispositif quantique alternatif au dispositif quantique représenté sur la figure 1, permettant de former autant de détecteurs de charge que de boites quantiques,
- La figure 6 montre une représentation schématique en vue de coupe du dispositif quantique représenté sur la figure 5,
- La figure 7 représente schématiquement en vue de dessus un dispositif quantique alternatif au dispositif quantique représenté sur la figure 1, permettant de positionner les détecteurs de charge à l'aplomb des boites quantiques,
- La figure 8 représente schématiquement en vue de dessus un dispositif quantique alternatif au dispositif quantique représenté sur la figure 7,
- La figure 9 montre une première représentation schématique en vue de coupe du dispositif quantique représenté sur la figure 8,
- La figure 10 est un schéma synoptique illustrant l'enchaînement des étapes d'un procédé de fabrication du dispositif quantique représenté sur la figure 1,
- Les figures 11A à 11L illustrent des étapes ou sous-étapes du procédé de fabrication représenté sur la figure 10, chaque figure montrant une vue en perspective et une vue de coupe du dispositif quantique réalisé au cours d'une des étapes ou sous-étapes.

Sauf précision contraire, un même élément apparaissant sur des figures différentes présente une référence unique.

### DESCRIPTION DETAILLEE

La présente invention se place dans le contexte des dispositifs électroniques quantiques et de leur procédé de fabrication. Plus particulièrement, l'invention vise à permettre, via des détecteurs de charge lus par réflectométrie, une détection efficace de l'état de charge des boites quantiques formées sur les dispositifs quantiques. En particulier, encore, l'invention vise à réduire l'espace occupé par ces détecteurs de charge sur le dispositif quantique pour offrir une architecture permettant de réaliser des qubits de spin à grande échelle.

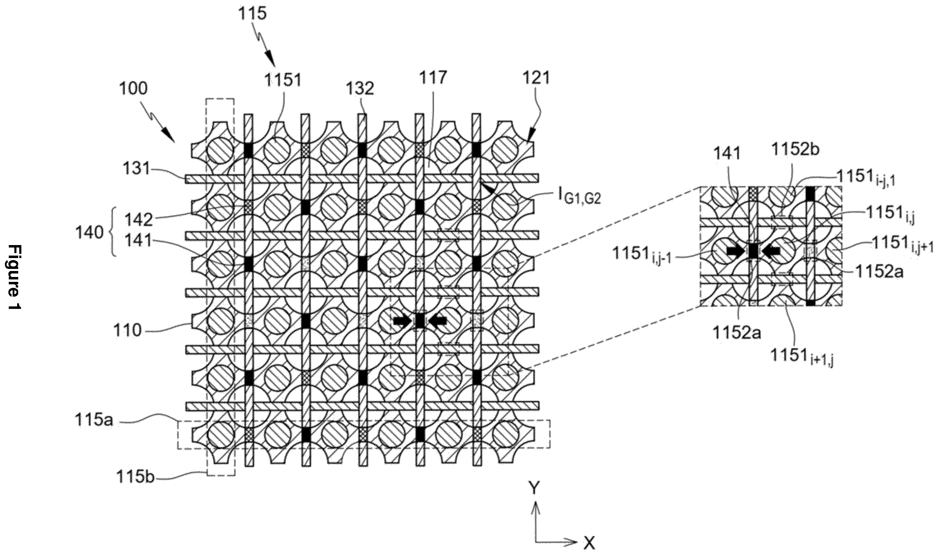

Les figures 1, 2, 3 et 4 représentent, sous une forme schématique, d'un dispositif quantique 100 selon un premier mode de réalisation

La figure 1 montre, sous forme schématique, une vue de dessus d'une partie du dispositif quantique 100 selon ce premier mode de réalisation.

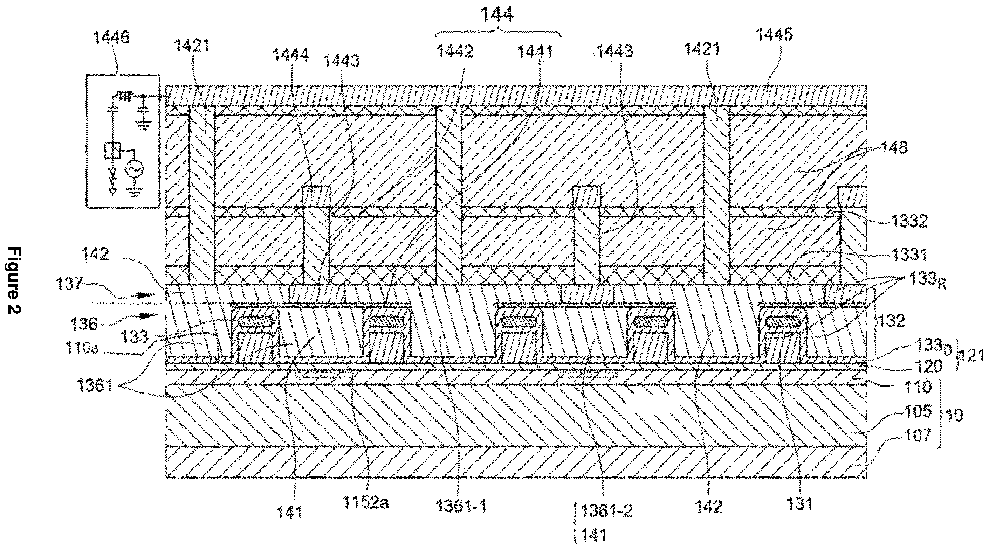

Les figures 2 à 4 montrent différentes vues d'une première variante de réalisation du dispositif quantique 100 représenté sur la figure 1.

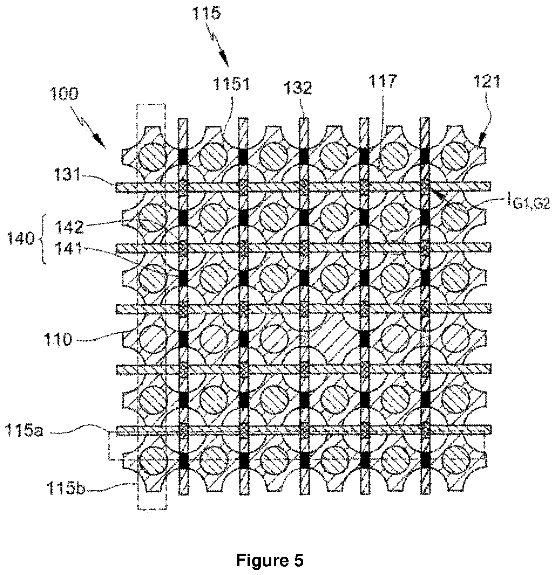

Les figures 5 à 6 montrent différentes vues d'une deuxième variante de réalisation du dispositif quantique 100 représenté sur la figure 1.

En référence à la figure 1, et de manière commune aux deux variantes de réalisation illustrées en figures 2 à 4 et en figures 5 à 6, le dispositif quantique 100 s'étend dans un plan {X,Y} et est formé à partir d'une couche semiconductrice 110. Le dispositif 100 comprend en outre un diélectrique 121, des premières et deuxièmes grilles 131, 132 et des détecteurs de charge 140. Typiquement, les premières grilles et les deuxièmes grilles sont des grilles de couplage. Ces éléments sont décrits en détail ci-après.

Dans la suite de la description, les termes « épaisseur » ou « hauteur » désignent des dimensions mesurées perpendiculairement au plan {X ; Y}. L'expression « dimension latérale » désigne une dimension mesurée dans le plan {X ;Y}.

Il est noté que le terme « grille » peut être utilisé ici pour désigner une ligne de grilles. On entend par « ligne de grilles » une ligne comportant une pluralité de grilles.

En outre, par la suite, les grilles surmontant une zone entre deux boites quantiques sont des grille contrôlant les barrières de potentiel entre les deux boites quantiques en question.

**La couche semiconductrice 110** présente une face avant 110a, illustrée en figure 2.

La couche semiconductrice 110 est adaptée pour former une matrice de boites quantiques. Dit autrement, la couche semiconductrice 110 présente des caractéristiques permettant de former une matrice 115 de boîtes quantiques 1151 en son sein. Ces boites quantiques sont représentées par des cercles hachurés sur la figure 1.

Le terme « matrice » désigne ici un arrangement des boites quantiques selon des lignes 115a et des colonnes 115b.

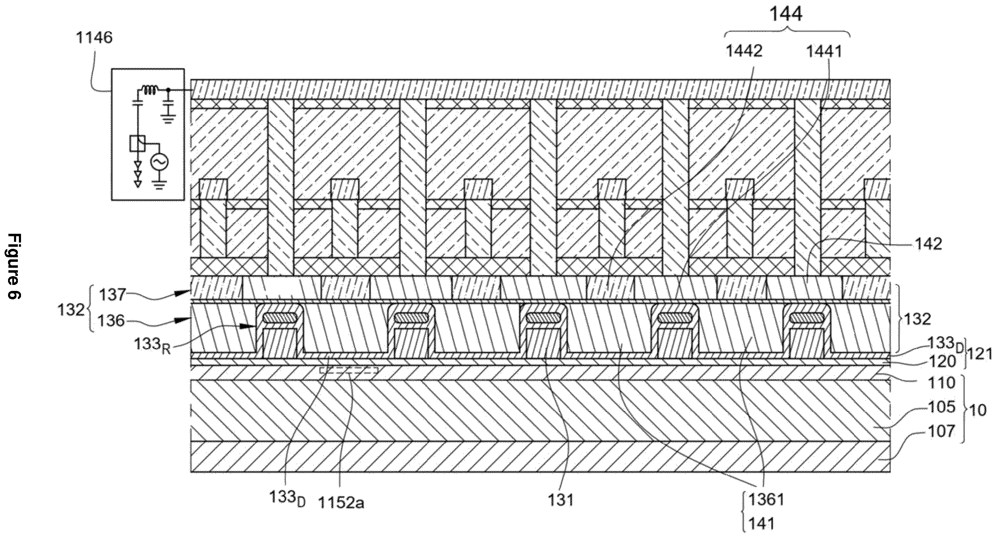

En référence à la figure 2 ou à la figure 6, la couche semiconductrice 110 présente une épaisseur comprise entre 5 nm et 35 nm et de manière préférée entre 10 nm et 20 nm, par exemple égale à 15 nm.

La couche semiconductrice 110 est de préférence une couche de silicium 110.

De préférence, cette couche de silicium 110 est issue d'un substrat 10 de type silicium sur isolant ou SOI (acronyme de « Silicium On insulator » en anglais).

Un tel substrat 10 est notamment illustré sur la figure 2. Il comprend un empilement, du bas vers le haut, d'une couche semiconductrice massive 105, d'une couche isolante 107, et de la couche semiconductrice 110 de silicium. La couche isolante 107 est disposée entre la couche semiconductrice massive 105 et la couche semiconductrice 110. La polarisation d'un tel substrat 10 permet de contrôler électro-statiquement des confinements de charges dans la couche semiconductrice 110.

La couche semiconductrice 110 peut, alternativement, être une couche de silicium massive.

La couche semiconductrice 110 peut, alternativement, être une hétérostructure semiconductrice comprenant un puit quantique ou un gaz d'électrons bidimensionnel (2DEG). De telles structures présentent des interfaces avec de faibles densités de défauts, facilitant le confinement des charges et leur contrôle électrostatique.

La couche semiconductrice 110 peut avantageusement présenter des trous 117. Ces trous 117 sont illustrés par des cercles blancs sur la figure 1. Ces trous 117 peuvent être par exemple obtenus par gravure de la couche semiconductrice 110.

Les trous 117 sont préférentiellement arrangés en lignes et en colonnes pour former une matrice de trous 117. Sur la figure 1, les lignes de trous 117 sont orientées dans une première direction X correspondant à la direction des lignes 115a de boites quantiques 1151. De manière analogue, les colonnes de trous 117 sont orientées dans une deuxième direction Y correspondant à la direction des colonnes 115b de boites quantiques 1151.

Les trous 117 sont disposés entre les lignes et les colonnes de boites quantiques. Préférentiellement, quatre trous 115 encadrent chaque zone correspondant à une boite quantique 1151.

Le diamètre des trous 117 est préférentiellement compris entre 20 nm et 50 nm. Ainsi, les trous 117 structurent la couche semiconductrice 110 pour confiner des charges dans chaque zone non gravée, c'est-à-dire dans la zone correspondant à la boite quantique 1151. La présence des trous 117 facilite ainsi la formation des boites quantiques 1151.

Le diélectrique 121 est disposé sur la face avant 110a de la couche semiconductrice 110 et est formé d'une ou de plusieurs couches, chaque couche étant formée d'un matériau diélectrique (cf. figure 2 ou figure 6).

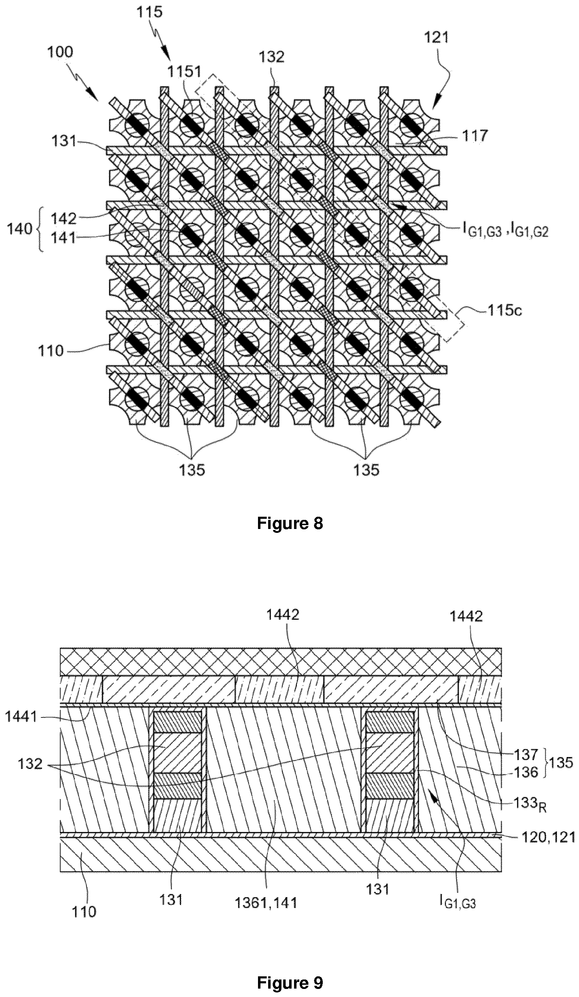

Selon une variante, représentée sur la figure 9, le diélectrique 121 est constitué d'une seule couche 120 de diélectrique qui recouvre la face avant 110a de la couche semiconductrice 110. La couche 120 de diélectrique présente une épaisseur préférentiellement comprise entre 5 nm et 10 nm et est électriquement isolant. La couche 120 de diélectrique est par exemple en oxyde de silicium (SiO2).

Selon une autre variante, illustrée sur la figure 2 et la figure 6, la couche 120 de diélectrique est recouverte, entre les premières grilles 131, par une autre couche de diélectrique, dite couche espaceur 133 (sur la figure 2, ces portions de couche d'espaceur 133 disposées sur la couche 120 de diélectrique sont notées 133_{D}). Dans cette configuration, le diélectrique 121 est l'empilement constitué de la couche 120 de diélectrique et de la couche espaceur 133_{D} disposée sur cette couche 120 de diélectrique. Cette variante de réalisation est plus aisée à réaliser que la variante dans laquelle le diélectrique 121 est constitué de la couche 120 de diélectrique uniquement. En effet, il n'est pas alors pas nécessaire de structurer la couche espaceur 133, une fois celle-ci déposée sur les premières grilles 131 et la couche 120 de diélectrique. Cette variante permet donc de s'affranchir d'une étape de gravure anisotrope de la couche espaceur 133 après son dépôt (puisque cette gravure n'est pas nécessaire). En contrepartie, comme il sera mieux compris par la suite, les deuxièmes grilles 132 sont un peu plus éloignées de la couche semiconductrice 110 et donc des boites quantiques 1151. Le contrôle électrostatique des boites quantiques ainsi que le couplage des détecteurs de charge 140 aux boites quantiques 1151 peut alors être sensiblement moins performant.

La couche espaceur 133 est formée d'un matériau diélectrique. Ce matériau est par exemple du SiO₂ ou de l'oxyde d'aluminium (Al₂O₃).

La couche espaceur 133 présente une épaisseur maximale qui dépend du matériau choisi : lorsque le matériau est du SiO₂, l'épaisseur maximale est par exemple de 5 nm ; lorsque le matériau est de l'AL₂O₃, l'épaisseur maximale peut être comprise entre 10 nm et 15 nm.

**Les premières grilles 131 et des deuxièmes grilles 132** sont des bandes conductrices formées à base d'un matériau conducteur choisi parmi les matériaux suivants : silicium cristallin dopé (ou Poly-Si dopé, tungstène (W), nitrure de titane (TiN).

**Les premières grilles 131** s'étendent entièrement sur le diélectrique 121 (précisément, elles s'étendent directement sur la couche 120 de diélectrique qui constitue, donc, un diélectrique de gille), selon une première direction X, illustrée en figure 1, qui correspond à l'orientation des lignes 115a de boites quantiques 1151.

Chaque première grille 131 présente une section dont la hauteur est préférentiellement comprise entre 5 nm et 50 nm, et de préférence égale à 25 nm. La dimension latérale et la hauteur de la section sont de préférence sensiblement identiques. La section de chaque première grille 131 est alors une section carrée.

Chaque première grille 131 est en outre recouverte, ou enrobée, sur ses flancs (c'est-à-dire ses faces latérales) et sa face supérieure (c'est-à-dire la face opposée à la couche 120 de diélectrique) de la couche espaceur 133 (cf. figure 2).

La couche espaceur 133 permet d'éviter un contact électrique entre les premières grilles 131 et les deuxièmes grilles 132, ou plus généralement entre les premières grilles 131 et des niveaux de grille supérieurs. Ainsi, ces niveaux de grilles supérieurs sont isolés entre eux.

**Les deuxièmes grilles 132** sont orientées selon une deuxième direction Y différente de la première direction X. Cette direction Y correspond à la direction des colonnes 115b de boites quantiques 1151.

Sur la figure 1, la deuxième direction est ici orientée à 90° par rapport à la première direction X. Naturellement, cette deuxième direction Y peut être orientée d'un angle différent de 90° par rapport à la première direction X.

Chaque deuxième grille 132 s'étend directement sur le diélectrique 121 (dans l'exemple de la figure 2, sur la couche espaceur 133 du diélectrique 121) et croise les premières grilles 131 au niveau de zones de croisement (notées I_{G1,G2} sur la figure 1) selon une configuration dite « imbriquée ».

Cette configuration imbriquée est décrite ci-après en relation avec la figure 2.

Selon cette configuration imbriquée, chaque deuxième grille 132 présente une hauteur qui est supérieure à la hauteur des premières grilles 131. De préférence, la hauteur des deuxièmes grilles 132 est supérieure de 20 nm à 50 nm à celle des premières grilles 131. La dimension latérale des deuxièmes grilles est de préférence identique à celle des premières grilles.

De plus chaque deuxième grille 132 s'étend :
- directement sur le diélectrique 121 entre deux premières grilles adjacentes (ou, dit autrement dans les espaces inter-premières grilles), et
- sur la couche espaceur 133 recouvrant les flancs et la face supérieure des premières grilles au niveau des zones de croisement IG1,G2.

En d'autres termes, chaque deuxième grille 132 passe par-dessus, ou chevauche, les premières grilles 131 enrobées de la couche espaceur 133 au niveau des zones de croisement I_{G1,G2}. Ce chevauchement permet de ne pas couper physiquement les premières grilles 131 au niveau des zones de croisement 133.

Grâce à la couche espaceur 133 qui est interposée entre les premières grilles 131 et les deuxièmes grilles 132, chaque deuxième grille 132 croise les premières grilles 131 sans qu'il y ait un contact électrique entre elles.

De plus, comme la hauteur des deuxièmes grilles 132 est supérieure à celle des premières grilles 131, on obtient, aux zones de croisements 133, des premières grilles 131 qui sont logées sous des renfoncements isolants 133_{R} des deuxièmes grilles 132.

Ces renfoncements isolants (aussi notés plus simplement « renfoncements 133_{R} » par la suite) sont visibles sur la figure 2. Chaque renfoncement isolant 133_{R} forme un pont isolant sous lequel passe une première grille 131.

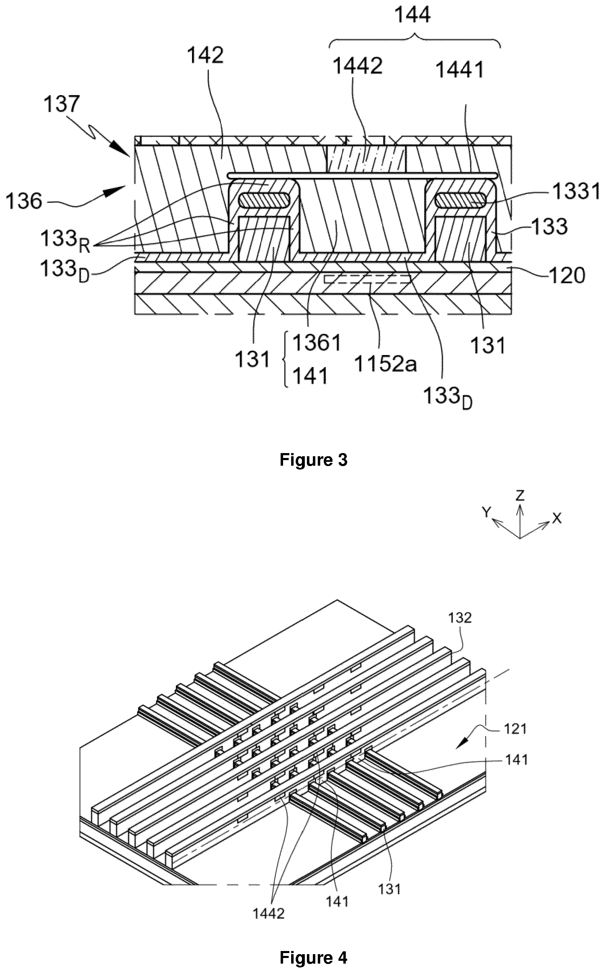

La figure 3 montre une vue agrandie de deux renfoncements isolants 133_{R} consécutifs.

Les renfoncements isolants 133_{R} présentent ici une couche de masque dur 1331 liée au processus de fabrication.

Comme le montre la figure 3, les renfoncements isolants 133_{R} définissent dans chaque deuxième grille 132 un étage inférieur 136, et un étage supérieur 137 qui sont conducteurs.

L'étage inférieur 136 présente un motif comprenant une pluralité de zones conductrices inférieures 1361 (cf. figure 2).

Chaque région conductrice inférieure 1361 est séparée des zones conductrices inférieures adjacentes par l'un des renfoncements isolants 133_{R}.

L'étage supérieur 137 forme une région conductrice supérieure continue 137. La configuration imbriquée permet donc de conserver la continuité électrique le long de chaque première grille 131 et le long de chaque deuxième grille 132.

Comme il sera décrit plus loin dans la description, ces zones conductrices inférieures 136 et la région conductrice supérieure 137 sont avantageusement utilisées pour former les détecteurs de charge 140.

Comme le montre la figure 1, la disposition des premières et deuxièmes grilles permet également de définir à la surface du diélectrique 121 un réseau d'espaces réguliers (aussi notés « mailles bidimensionnelles » par la suite). Chaque maille bidimensionnelle correspond à la zone d'une boite quantique 1151.

Chaque maille bidimensionnelle comprend l'espace de diélectrique libre défini à l'intersection entre deux premières grilles adjacentes et deux deuxièmes grilles adjacentes. Chaque maille bidimensionnelle comprend également le contour fermé formé par les portions des grilles de l'intersection.

Dans l'exemple de la figure 1, les directions X, Y des premières et deuxièmes grilles 131, 132 ici sont orthogonales l'une par rapport à l'autre. Les mailles bidimensionnelles sont de forme carrées.

Les directions X, Y des premières et deuxièmes grilles 131, 132 peuvent alternativement être orientées avec un angle différent de 90°.

Lorsque la couche semiconductrice 110 comporte des trous 117 comme illustré sur la figure 1, les directions X et Y des premières grilles et deuxièmes grilles correspondent aussi, respectivement, aux directions des lignes et des colonnes de trous 117. Les premières et deuxièmes grilles sont de plus disposées de sorte qu'il y ait un trou en regard de chaque zone de croisement I_{G1,G2}. Ainsi, un trou 117 est disposé à chaque sommet des mailles bidimensionnelles.

Le contrôle indépendant de chaque première et deuxième grille 131, 132 permet de contrôler électro-statiquement et avec des interactions de courte portée une boite quantique 1151 dans chaque région de la couche semiconductrice 110 située à l'aplomb d'une maille bidimensionnelle.

Ce contrôle est facilité par la présence des trous 117 puisque ceux-ci permettent de confiner (de manière non électrostatique) des charges au niveau des régions de la couche semiconductrice formant les boites quantiques 1151.

Chaque région de la couche semiconductrice 110 formant une boite quantique présente des dimensions latérales, définies dans le plan {X,Y}, qui sont préférentiellement comprises entre 5 nm et 100 nm, et préférentiellement égales à 50 nm. L'épaisseur de la région de la couche semiconductrice 110 formant une boite quantique est par ailleurs préférentiellement comprise entre 5 nm et 30 nm, et préférentiellement égale à 15 nm.

La distance entre deux boites quantiques voisines, c'est-à-dire deux boites quantiques formées en regard de deux mailles bidimensionnelles voisines, est préférentiellement comprise entre 25 nm et 125 nm.

Plus précisément, le contrôle des premières et deuxièmes grilles permettent de contrôler par effet de champ la conduction de barrières tunnel 1152a, 1152b situées de part et d'autre (selon les directions X et Y) de chaque boite quantique.

Sur la partie de la figure 1 représentant une vue agrandie d'une maille bidimensionnelle, ces barrières tunnel 1152a, 1152b sont représentées par des rectangles en pointillés. Chaque barrière tunnel notée 1152a est ici située en regard d'une deuxième grille 132 et relie la boite quantique 1151_{i,j} à la boite quantique adjacente 1151_{i-1,j} (ou 1151_{i-1,j}) formée sur la même ligne (115a) du réseau de mailles bidimensionnelles. Chaque barrière tunnel notée 1152b est ici située en regard d'une première grille 131 et relie la boite quantique 1151_{i,j} à la boite quantique 1151_{i,j+1} (ou 1151_{i,j-1}) adjacente formée sur la même colonne (115b) du réseau de mailles bidimensionnelles.

Les barrières tunnel 1152a, 1152b présentent préférentiellement des dimensions latérales inférieures à celles des boites quantiques 1151, par exemple des dimensions latérales comprises entre 5 nm et 30 nm. Leur épaisseur est en revanche similaire à celle des boites quantiques 1151.

D'après ce qui précède, les premières grilles 131 sont disposées à l'aplomb de premières barrières tunnel 1152b, et les deuxièmes grilles sont disposées à l'aplomb de deuxièmes barrières tunnels 1152a. Chaque première barrière tunnel 1152b relie deux boites quantiques voisines disposées dans une même colonne 115b de la matrice de boites quantiques, tandis que chaque deuxième barrière tunnel 1152a relie deux boites quantiques voisines disposées dans une même ligne de cette matrice 115.

**Chaque détecteur de charge 140** comporte un îlot quantique conducteur 141 (noté aussi îlot 141 par la suite) et un réservoir de charge 142.

Chaque détecteur de charge 140 peut être mesuré par réflectométrie.

Comme le montrent les figures 2 et 6, l'ilot 141 de chaque détecteur de charge 140 est formé entre deux premières grilles 131 adjacentes et directement sur le diélectrique 121.

Ainsi, cet îlot 141 est formé au même niveau que celui des premières et deuxièmes grilles 131, 132. L'expression « au même niveau » signifie que chaque îlot 141 est formé entre la face inférieure des premières grilles et la face supérieure des deuxième grilles. Cela permet d'obtenir un dispositif quantique 100 compact (en termes de hauteur). Autrement dit, chaque ilot 141 de chaque détecteur de charges 140 est situé dans un même plan horizontal que les premières grilles 131. De même, le ou les réservoirs de charges 142 (i.e., source ou drain) de chaque détecteur de charges 140 sont situés dans un même plan horizontal que les deuxièmes de grilles 132, notamment dans un même plan horizontal que la région conductrice supérieure 137 des deuxièmes grilles 132.

L'ilot 141 et chaque réservoir de charge 142 de chaque détecteur de charge 140 peut être dans un même matériau que le matériau des deuxièmes grilles.

De plus, comme il sera décrit plus loin dans la description en relation avec le procédé de fabrication, le fait de former les îlots conducteurs 141 entre des premières grilles 131 offre l'avantage de pouvoir utiliser ces premières grilles 131 comme repère d'alignement au moment des étapes de fabrication des îlots conducteurs 141. Dit autrement, les premières grilles permettent d'« auto-aligner» les îlots 141. Cet auto-alignement facilite ces étapes de fabrication.

La compacité et la simplicité de fabrication sont des atouts pour la mise à l'échelle des processeurs quantiques.

De manière commune aux deux variantes de réalisation illustrées respectivement en figure 2 et 5, chaque îlot 141 est formé dans l'une des zones conductrices inférieures 1361 d'une deuxième grille 132. Ces zones conductrices inférieures 1361 sont, comme décrit précédemment, comprises entre deux premières grilles 131.

L'ilot 141 de chaque détecteur de charge ainsi « posé » sur le diélectrique 121 à l'aplomb d'une barrière tunnel 1152a. Chaque îlot 141 est ainsi couplé à l'une et l'autre des boites quantiques 1151 disposées, dans le plan de la couche semiconductrice 110, de part et d'autre de cette barrière tunnel 1152a. Ce couplage est matérialisé par des flèches sur la partie de la figure 1 représentant une vue agrandie d'une maille bidimensionnelle. Chaque détecteur de charge 140 est alors partagé entre au moins deux boites quantiques 1151.

Plusieurs îlots 141 (cf. figure 2) sont formés dans une même deuxième grille 132.

Dans cette deuxième grille 132, les zones conductrices inférieures 1361 définissant un îlot 141 sont recouvertes d'une couche tunnel 1441. Cette couche tunnel 1441 est agencée au sein de la deuxième grille 132. Cette couche tunnel 1441 a pour effet d'isoler électriquement l'îlot 141 de l'étage conducteur supérieur 137 et des autres îlots 141 de la deuxième grille 132. Elle a aussi pour effet de permettre la formation d'un courant tunnel en son sein.

Tous les détecteurs de charge 140 de cette deuxième grille ont un réservoir de charge 142 commun, formé, au moins, par l'étage supérieur 137 de cette deuxième grille 132. Le réservoir de charge 142 commun est relié par couplage tunnel à chaque îlot conducteur grâce à la couche tunnel 1441.

Enfin, chaque détecteur de charge 140 de cette deuxième grille 132 comporte un terminal de grille 144 (le terme « terminal » de grille étant équivalent ici au terme « contact » de grille), formé par la couche tunnel 1441 et un motif de diélectrique appelé motif barrière 1442.

Ce motif barrière 1442 traverse la région conductrice supérieure 137 depuis la couche tunnel 1141 jusqu'à la face supérieure de la grille 132. Ce motif barrière 1442 est à l'aplomb d'une partie de l'îlot conducteur 141. Il est, de plus, enrobé de la région conductrice supérieure 137.

Ainsi, l'ilot conducteur 141, le réservoir de charge 142 et le terminal de grille de chaque détecteur 140 est formé dans une deuxième grille 132.

L'utilisation partagée des deuxièmes grilles 132 permet de réduire l'empreinte globale (latérale et verticale) du détecteur de charge 140 dans le dispositif quantique 100.

L'utilisation, en particulier, de la zone conductrice supérieure 137 pour former/incorporer les réservoirs de charge 142, 143 offre un avantage supplémentaire pour intégrer les fonctions d'adressage et de lecture des détecteurs de charge 140. En effet, cette zone conductrice supérieure 137 est aisément accessible pour une reprise de contact électrique par le haut ou/et pour une reprise de contact électrique aux extrémités des deuxièmes grilles.

Une structure de contrôle de la polarisation du terminal de grille 144 de chaque ilot 141 peut ainsi comprendre des vias conducteurs de grille 1433 (aussi notés vias de grille 1433 par la suite). Comme le montre la figure 2, chaque via de grille 1433 présente une extrémité inférieure disposée sur la face supérieure de la deuxième grille 132, au contact d'un motif barrière 1442.

Une structure de lecture de chaque îlot 141 peut en outre comprendre un ou plusieurs vias conducteurs de lecture 1421 (aussi notés vias de lecture 1421 par la suite). Chaque via de lecture 1421 présente une extrémité disposée sur la face supérieure de la deuxième grille 132, au contact de la région conductrice supérieure 137. Dans l'exemple de la figure 2, plusieurs vias de lecture 1421 sont agencées sur une même deuxième grille 132.

Dans ce cas, une couche d'encapsulation 148 est disposée sur la face supérieure de la deuxième grille pour enrober les vias de grille 1443 et les vias de lecture 1421. Cette couche d'encapsulation 148 peut être formée d'un diélectrique, par exemple de SiO₂. On note, sur la figure2, la présence d'une couche de masque dur 1332 interposée au sein de la couche d'encapsulation 148. Cette couche de masque dur 1332 est liée au processus de fabrication.

Le nombre d'îlots conducteurs 141 formés dans une même deuxième grille 132 dépend de la structure interne de cette deuxième grille 132.

Selon la première variante de réalisation, illustrée sur les figures 1, 2, 3 et 4, la structure interne de la deuxième grille 132 est d'un premier type permettant de former un îlot 141 dans une région conductrice inférieure 1361 sur deux.

Selon ce premier type de structure interne, et en référence à la figure 2, une région conductrice inférieure 1361-1 sur deux prolonge la région conductrice supérieure 137 vers le diélectrique 121.

Cette région 1361-1 définit une région conductrice inférieure complémentaire 1361-2 (aussi notée région inférieure complémentaire 1361-2 par la suite).

La région inférieure complémentaire 1361-2 est recouverte d'une couche barrière inférieure, appelée couche tunnel 1441. Cette couche tunnel 1441 est disposée sur les renfoncements 133_{R} adjacents à la région inférieure complémentaire 1361-2. Dit autrement, la couche tunnel 1441 forme un couvercle sur la région inférieure complémentaire, ce couvercle prenant appui sur les renfoncements adjacents 133_{R}. La couche barrière 1441 est une couche barrière de charges.

La couche tunnel 1441 présente des caractéristiques permettant de réaliser un couplage tunnel en son sein.

La couche tunnel 1441 peut être formée d'oxyde d'aluminium (Al2O3).

La couche tunnel 1441 peut être formée d'oxyde de silicium (SiO₂). Dans ce cas, la couche tunnel 1441 présente une épaisseur comprise entre 1 nm et 3 nm.

De préférence, la couche tunnel 1441 est formée à base d'un oxyde d'hafnium (HfO2). Ce matériau présente en effet une résistance programmable à ajuster à une valeur comprise entre quelques kiloohms et quelques dizaines de kiloohms. La couche tunnel 1441 présente alors préférentiellement une épaisseur comprise entre 5 nm et 10 nm.

La couche tunnel 1441 permet de définir un îlot 141 dans la région inférieure complémentaire 1361-2.

L'étage supérieur 137 et la région conductrice inférieure 1361-1 qui se prolonge vers cet étage supérieur 137 forment le réservoir de charge 142 de l'îlot 141 formé dans la région inférieure complémentaire 1361-1. Le couplage tunnel entre ce réservoir de charge 143 et les îlots141 est effectué dans la couche tunnel 1441.

Le premier type de structure interne prévoit également qu'un motif barrière 1442 formant une couche barrière supérieure 1442 s'étende à travers la région conductrice supérieure 137, depuis la couche tunnel 1441 jusqu'à la face supérieure de la deuxième grille 132.

Ce motif barrière 1442 est enrobé par la région conductrice supérieure 137. Ainsi, la région conductrice supérieure 137 reste continue le long de la deuxième grille 132. Le motif barrière 1442 est et disposé à l'aplomb d'une partie au moins de la région conductrice inférieure complémentaire 1361-2.

Le motif barrière 1442 est formé d'un matériau similaire à celui formant la couche tunnel 1441. De la sorte, il est adapté à réaliser un couplage tunnel en son sein. Le motif barrière est de préférence formé d'un matériau choisi parmi les matériaux suivants : SiO₂, Al₂O₃, HfO₂.

Le motif barrière 1442 forme, avec la portion de la couche tunnel 1441 correspondante, le terminal de grille 144 de l'îlot 141 formé dans la région inférieure complémentaire 1361-2. Le motif barrière 1442 est un motif barrière de charges.

Comme le montre la figure 4, chaque deuxième grille 132 peut présenter cette structure du premier type. Alternativement, une deuxième grille 132 peut présenter cette structure du premier type.

Les régions conductrices inférieures 1361-2 choisies pour définir les ilots 141 dans une deuxième grille 132 donnée sont préférentiellement décalées par rapport à celles choisies pour une deuxième grille 132 voisine.

De la sorte, et en référence à la figure 1, les ilots 141 sont agencés en quinconce les uns par rapport aux autres dans l'ensemble formé par les deuxièmes grilles 132. En conséquence, les détecteurs de charge 140 sont aussi disposés en quinconce les uns par rapport aux autres. Cet arrangement en quinconce permet de garantir une bonne sensibilité de mesure avec un nombre réduit de détecteurs de charge 140.

De retour à la figure 2, la structure de contrôle de la polarisation des terminaux de grille 144 comprend préférentiellement des lignes de métallisation, dites lignes de lecture 1445, qui sont couplées à un circuit de réflectométrie LC 1446. Chaque ligne de lecture 1445 est reliée électriquement aux vias de lecture 1421 disposés sur une même deuxième grille 132.

Chaque ligne de lecture 1145 peut coupler des portions conductrices 137 situées sur une même ligne 115a de la matrice 115 de boites quantiques 1151.

Alternativement, Chaque ligne de lecture 1145 peut coupler des portions conductrices 137 situées sur une même diagonale 115c de la matrice 115 de boites quantiques 1151.

De plus, la structure de contrôle de la polarisation des terminaux de grilles 144 peut comprendre des lignes de métallisation 1444, dite lignes de grille 1444, couplées à une source de tension. Chaque ligne de grille 1444 est de préférence reliée aux vias de grilles 1443 disposés sur une même ligne de la matrice 115 de boites quantiques.

L'association des structures de lecture et de contrôle des terminaux de grille permet de réaliser une lecture individuelle des détecteurs de charge 140.

Selon la deuxième variante de réalisation, illustrée sur les figures 5 et 6, la structure interne de la deuxième grille 132 est d'un deuxième type permettant de former un îlot 141 dans chaque région conductrice inférieure 1361. Ce deuxième type permet ainsi, par rapport au premier type, de doubler le nombre de détecteurs charge 140 formés dans une même deuxième grille 132. Comme le montre la figure 5, il y a alors autant de détecteurs de charge 140 que de boites quantiques 1151.

En augmentant ainsi le nombre de détecteurs de charge 140, on permet de mesurer chaque boite quantique au plus près de celle-ci. Cela améliore la sensibilité de la mesure des boites quantiques.

Le deuxième type de structure interne diffère du premier type en ce que toutes les régions conductrices inférieures 1361 de la deuxième grille 132 sont recouvertes de la couche tunnel 1441. La couche tunnel 1441 s'étend alors dans tous le plan de la deuxième grille, au niveau de la face supérieure des renfoncements 133_{R} de cette deuxième grille (cf. figure 6).

D'autre part, il y a un motif barrière 1442 à l'aplomb de chaque région conductrice inférieure 1361. Comme dans la structure du premier type, le motif barrière 1442 traverse la région conductrice supérieure 137 jusqu'à la couche tunnel 1441 et est enrobé de la région conductrice supérieure 137.

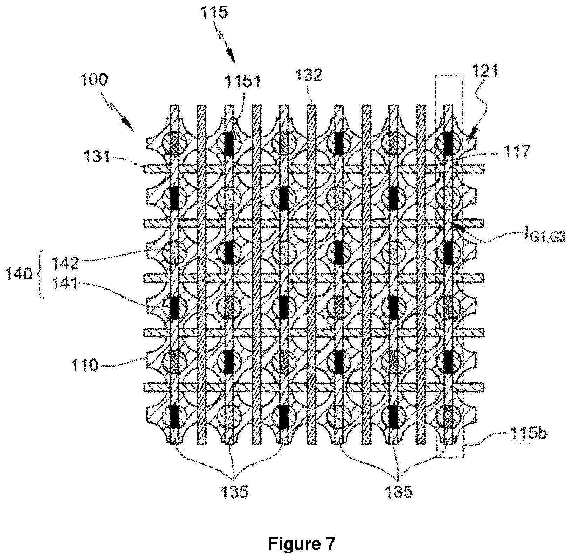

Les figures 7, 8 et 9 montrent un deuxième mode de réalisation du dispositif quantique 100.

Le deuxième mode de réalisation diffère du premier mode de réalisation, illustré en figures 1 à 6, en ce que les détecteurs de charge 140 ne sont pas formés dans les deuxièmes grilles 132 mais dans des troisièmes grilles 135 destinées à contrôler le potentiel chimique des boites quantiques 1151. Les troisièmes grilles 135 sont donc des grilles d'accumulation de charges.

Comme le montre la figure 9, les deuxièmes grilles 132 sont alors recouvertes, sur leurs flancs et leur face supérieure, d'une couche 133' de matériau isolant formant un espaceur 133' analogue à l'espaceur 133. L'espaceur 133' permet alors d'isoler électriquement ces deuxièmes grilles des troisièmes grilles 135.

On note que sur cette figure 9, le diélectrique 121 est la couche 120 de diélectrique.

Les troisièmes grilles sont des bandes conductrices formées à base d'un matériau conducteur similaire à celui formant les premières et deuxièmes grilles.

Comme le montrent les figures 7 et 8, ces troisièmes grilles 135 sont distinctes des deuxièmes grilles 132 et sont toutes orientées dans une direction Y' différente de la première direction X des premières grilles 131. Les troisièmes grilles et s'étendent à l'aplomb des boites quantiques 1151.

La figure 7 montre une première variante de réalisation du deuxième mode de réalisation. Selon cette première variante, les troisièmes grilles sont orientées à 90° par rapport aux premières grilles 131. De plus, chaque troisième grille 135 est disposée entre deux deuxièmes grilles adjacentes, à l'aplomb des boites quantiques disposées sur une même colonne 115b de la matrice 115 de boites quantiques.

Les troisièmes grilles 135 s'étendent directement sur le diélectrique 121 et t croisent les premières grilles 131 (cf. figure 7) selon une configuration imbriquée analogue à la configuration imbriquée décrite précédemment (en relation avec les deuxièmes grilles132). Les zones de croisement entre les premières grilles et les troisièmes grilles sont notées avec la référence I_{G1,G3} sur les figures 7 et 8.

La figure 8 montre une deuxième variante de réalisation du deuxième mode de réalisation. Selon cette deuxième variante, les troisièmes grilles sont orientées à 45° par rapport aux premières et aux deuxièmes grilles 131, 132. Chaque troisième grille 135 s'étend à l'aplomb des boites quantiques disposées sur une même diagonale 115c de la matrice 115 de boites quantiques.

Les troisièmes grilles 135 s'étendent directement sur le diélectrique 121 et croisent les premières et les deuxièmes grilles selon la même configuration imbriquée que celle décrite précédemment.

Les zones de croisement entre les premières grilles et les troisièmes grilles I_{G1,G3} correspondent aux zones de croisement entre les premières et les deuxièmes grilles I_{G1,G2}.

La figure 9 montre, sous forme schématique, une vue de coupe d'une troisième grille du dispositif représenté en figure 8.

Comme le montre la figure 9, chaque troisième grille 135 s'étend directement sur le diélectrique 121 entre deux premières grilles 131 adjacentes (ou, dit autrement dans les espaces inter-premières grilles), et passe par-dessus, ou chevauche, les premières grilles 131 enrobées de la couche espaceur 133 au niveau des zones de croisement I_{G1,G3}.

La hauteur des troisièmes grilles 135 est supérieure à celle des deuxièmes grilles 132. De préférence, cette hauteur des troisièmes grilles est supérieure de 20 nm à 50 nm à celle des deuxièmes grilles 132.

Cette configuration imbriquée permet de définir une structure en deux étages (un étage supérieur conducteur continu 137 et un étage inférieur formé d'une pluralité de régions conductrice inférieures 1361) analogue à la structure des deuxièmes grilles illustrée en figure 6.

Cette configuration imbriquée permet, ainsi, de former dans chaque troisième grille 135, ou dans une troisième grille 135 sur deux, la structure interne décrite précédemment en relation avec le premier mode de réalisation.

Dans l'exemple montré sur la figure 7, chaque troisième grille présente la structure interne du premier type, illustrée en figure 2.

Ainsi, dans ces troisièmes grilles 135, une région conductrice inférieure 1361 sur deux forme un îlot conducteur 141. De plus, la région conductrice supérieure 137 forme le réservoir de charge 142 commun à tous les îlots formés dans la troisième grille 135, et des motifs barrières 1442 enrobés de la région conductrice supérieure 137 forment les terminaux de grilles 144 (cf. figure 9).

Cette configuration permet de positionner chaque îlot conducteur 141 à l'aplomb d'une boite quantique (à la différence du premier mode de réalisation, où les îlots 141 sont à l'aplomb des barrières tunnel).

Cette disposition permet une mesure plus localisée de l'état de charge de la boite quantique 1151 que lorsque le détecteur de charge 140 est à l'aplomb d'une barrière tunnel 1152b. En effet, un détecteur de charge 140 disposé à l'aplomb d'une boite quantique est plus sensible à cette dernière car plus proche qu'un détecteur de charge disposé à l'aplomb d'une barrière tunnel. Il est, toutefois, moins sensible aux boites quantiques voisines.

Comme dans le premier mode de réalisation, les îlots 141 sont ici disposés en quinconce les uns par rapport aux autres.

Naturellement, les troisièmes grilles 135 peuvent alternativement présenter la structure du deuxième type, illustrée en figure 4. Dans ce cas, dans les troisièmes grilles 135, chaque région conductrice inférieure 1361 forme un îlot conducteur 141. Un détecteur de charge 140 est alors disposé à l'aplomb de chaque boite quantique 1151.

Dans l'exemple montré sur la figure 8, chaque troisième grille présente la structure interne du deuxième type, illustrée en figure 6.

Ainsi, comme dans la première variante de réalisation illustrée en figure 7, chaque région conductrice inférieure 1361 forme un îlot conducteur 141. De plus, la région conductrice supérieure 137 forme le réservoir de charge commun à tous les îlots formés dans la troisième grille, et des motifs barrières enrobés de la région conductrice supérieure forment les drains 142.

Cette configuration permet de positionner un îlot conducteur à l'aplomb de chaque boite quantique.

Naturellement, les troisièmes grilles peuvent alternativement présenter la structure du premier type, illustrée en figure 2. Dans ce cas, dans les troisièmes grilles 135, une région conductrice inférieure 1361 sur deux forme un îlot conducteur 141. Un détecteur de charge 140 est alors partagé entre deux boites quantiques 1151.

D'après ce qui précède, le dispositif quantique 100 comprend deux ensembles de grilles de contrôle des boites quantiques 1151 : le premier ensemble comporte les premières grilles 131 ; le deuxième ensemble comporte des grilles qui s'étendent directement sur le diélectrique 121 et croisent les premières grilles 132. Le deuxième ensemble comporte, au moins, les deuxièmes grilles 132.

De plus, l'îlot conducteur 141 de chaque détecteur de charge 140 est formé par une région de l'une des grilles du deuxième ensemble, ladite région étant comprise entre deux premières grilles 131 adjacentes et disposée directement sur le diélectrique 121.

Dans une variante de réalisation, le détecteur de charge 140 peut ne comporter qu'un seul réservoir de charges 142, i.e., qu'il ne comporte qu'une source ou qu'un drain.

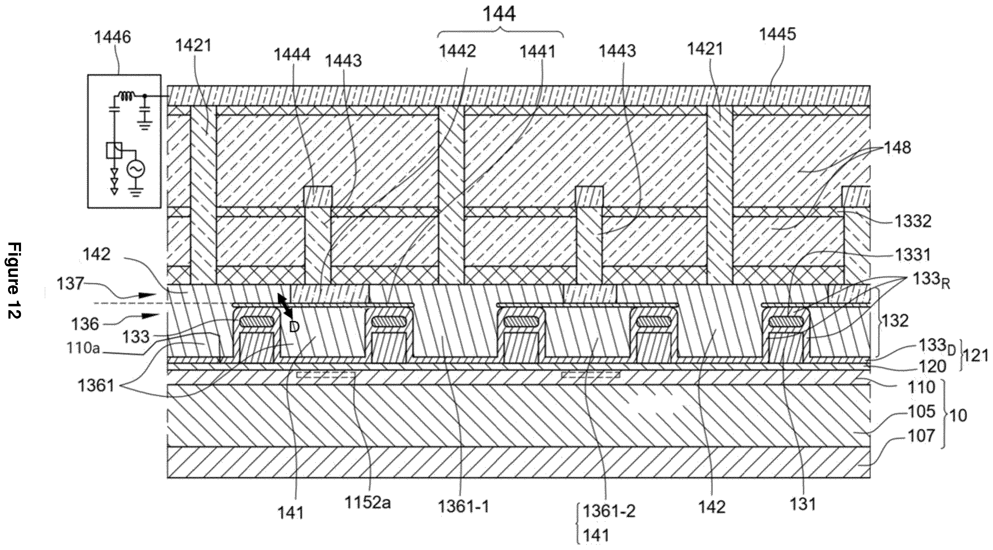

Dans cette variante de réalisation illustrée sur la figure 12, la connexion de l'îlot 141 de chaque détecteur de charge 140, ou d'une partie de ceux-ci, au réservoir de charge 142 afférent peut être réalisée uniquement sur un côté de l'ilot 141. En effet, en lien avec la figure 12, selon les dimensions (notamment la largeur) du motif barrière 1442 et/ou selon l'alignement de la couche tunnel 144 avec l'ilot 141, il est possible d'avoir une configuration où la connexion de l'ilot 141 du ou des détecteurs de charges 140 considérés (et donc de chaque SET afférent) avec l'étage supérieur 137 (formant le réservoir de charges 142 commun) se fait seulement sur l'un des côtés de cet ilot 141, indiqué par la double flèche D sur cette figure.

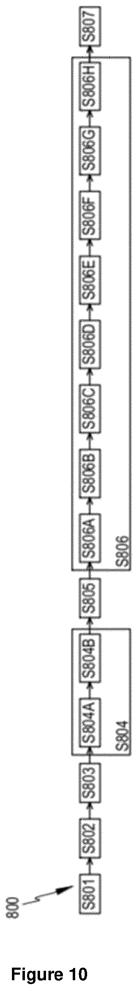

La figure 10 montre une représentation schématique d'un schéma synoptique d'un procédé 800 de fabrication du dispositif quantique 100 illustré en figure 1 et 2.

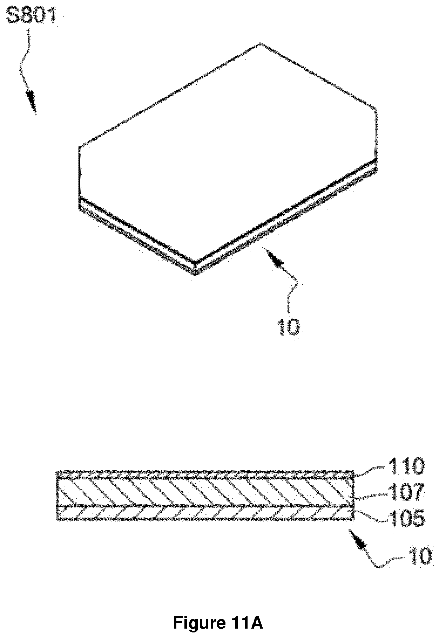

Les figures 11A à 11L sont des représentations schématiques en perspective et en vue de coupe illustrant certaines étapes ou sous-étapes du procédé de fabrication 800.

Le procédé de fabrication 800 débute par une première étape S801 de fourniture du substrat SOI 10 comprenant sur l'une de ses faces la couche semiconductrice 110. Cette première étape S801 est illustrée sur la figure 11A.

Cette étape S801 est suivie d'une étape S802 (cf. figure 10) de définition de l'agencement de la matrice de boites quantiques 115 et des barrières tunnel 1152 dans la couche semiconductrice 110. Dit autrement, cette étape S802 consiste à déterminer les régions de la couche semiconductrice 110 dans lesquelles seront formées les boites quantiques 1151, ainsi que les régions dans lesquelles seront formées les barrières tunnel 1152a, 1152b.

Cette étape S802 peut être suivie d'une étape de gravure de la couche semiconductrice 110 pour obtenir les trous 117.

Le procédé 800 se poursuit avec une étape S803 (cf. figure 10) de dépôt, sur la totalité de la face supérieure de la couche semiconductrice 110, d'une première couche diélectrique 121 avec le matériau de la couche 120 de diélectrique du du diélectrique 121

Cette troisième étape S803 est suivie d'une quatrième étape S804 visant à former conjointement les premières grilles 131, et la couche tunnel 1441.

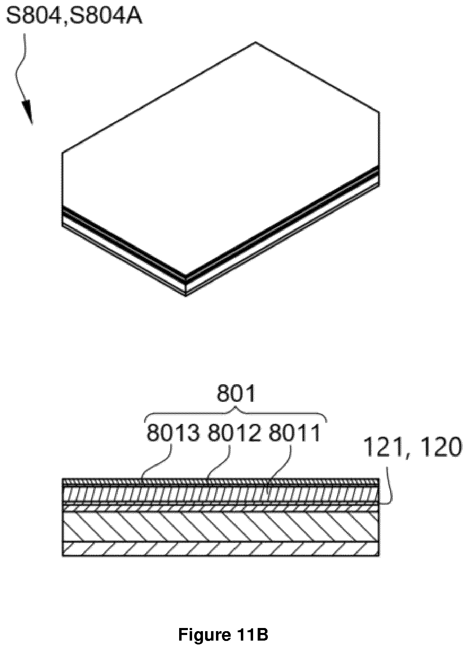

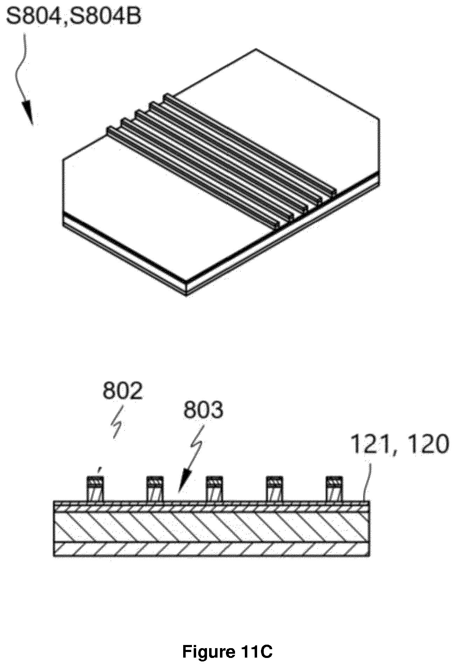

En référence à la figure 10, cette étape S804 comporte les sous-étapes successives S804A et S804B. Ces sous-étapes sont également illustrées en figure 11B et 11C.

En référence à la figure 11B, la sous-étape S804A est une sous-étape de formation d'un premier empilement 801 sur toute la surface de l'espaceur 120, par :

Dépôt, sur la couche 120 de diélectrique, d'une première couche conductrice 8011 du matériau conducteur des premières grilles 131,

Dépôt, sur la première couche conductrice 8011, d'une deuxième couche de diélectrique 8012 du matériau formant l'espaceur 133,

Dépôt, sur la deuxième couche de diélectrique 8012, d'une première couche de masque dur 8013.

La sous-étape S804B est une sous-étape de structuration en trois dimensions du premier empilement 801 pour former des premières bandes 802 parallèles les unes aux autres, disposées sur la couche 120 de diélectrique en regard des premières barrières tunnel 1152a définies précédemment.

La sous-étape de structuration S804B est réalisée par définition d'un masque de gravure de gravure dans la première couche de masque dur 8013, puis par gravures successives, au travers du masque de gravure, de la deuxième couche diélectrique 8012 et de la première couche conductrice 8011, avec arrêt sur la couche 120 de diélectrique.

Le dispositif obtenu à l'issue de cette sous-étape S804B est représenté sur la figure 11C. Comme le montre cette figure 11C, les bandes 802 obtenues sont séparées par des espaces libres 803 de la couche 120 de diélectrique.

L'étape S804 est suivie d'une cinquième étape S805 consistant à réaliser un dépôt conforme d'une couche d'encapsulation 8041 de manière à recouvrir les limites extérieures des premières bandes 802 et des espaces libres 803. La couche d'encapsulation 8041 est réalisée avec le matériau de l'espaceur 133. Ce dépôt peut être suivi d'une planarisation de la couche d'encapsulation 8041 sur les faces supérieures des premières bandes 801.

A l'issue de cette étape S805, les renfoncements isolants 133_{R} des deuxièmes grilles 132 sont préparés.

Le procédé 800 se prolonge avec une sixième étape S806 dont le but est de former conjointement les deuxièmes grilles 132 et les des îlots 141 dans ces deuxièmes grilles 132.

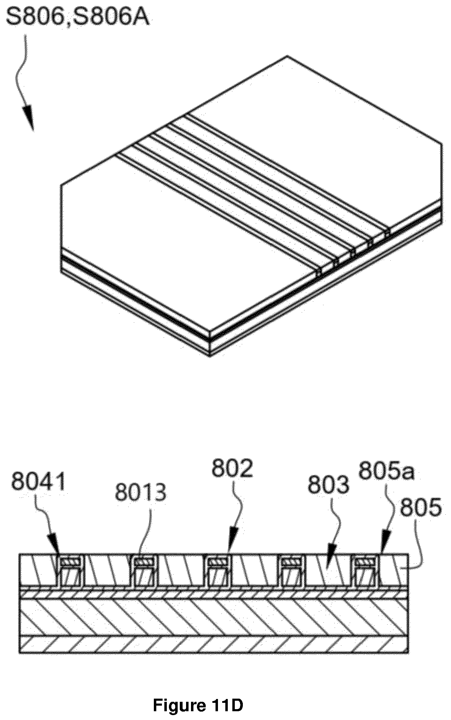

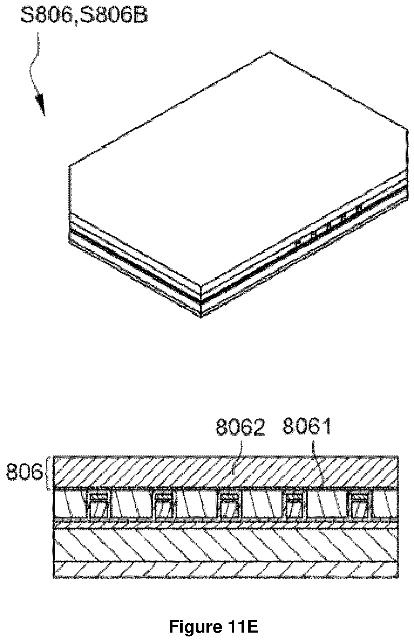

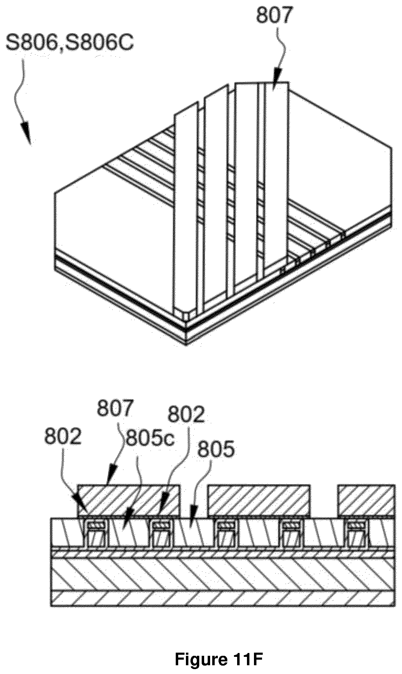

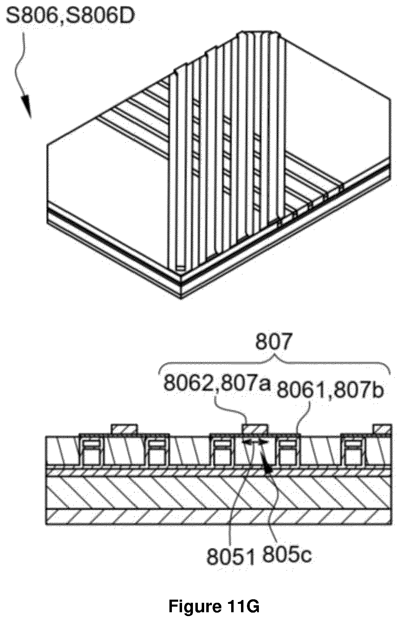

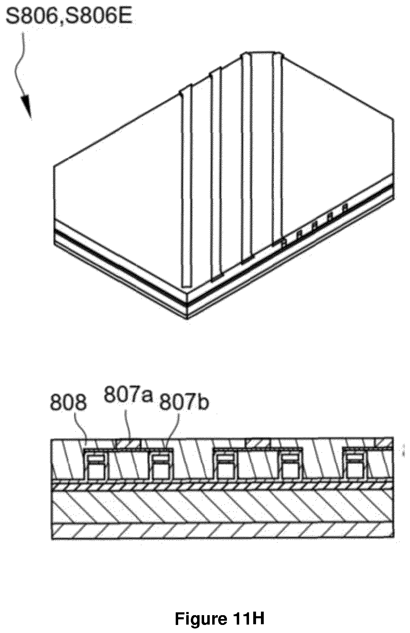

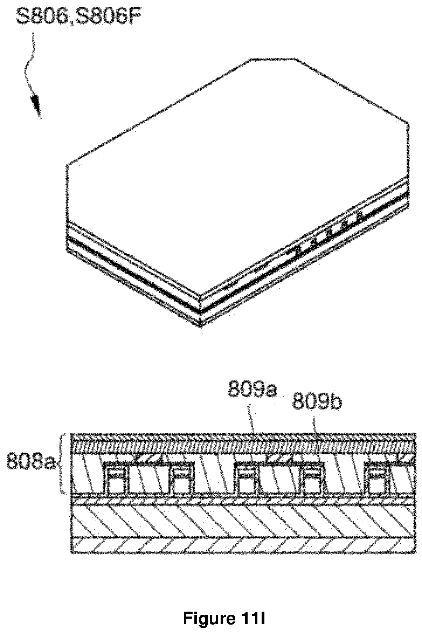

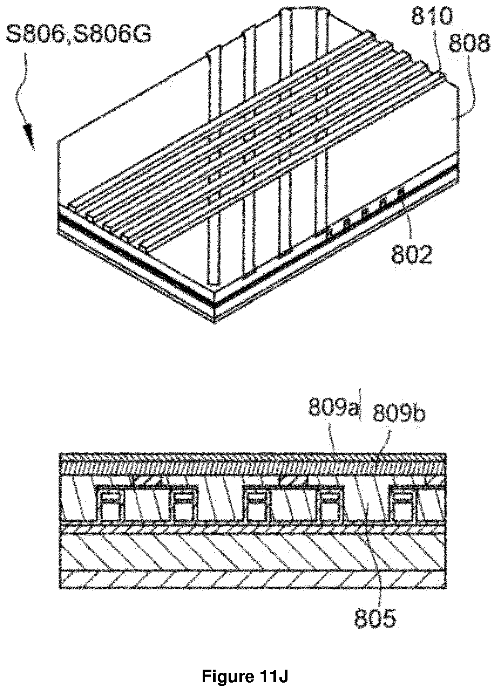

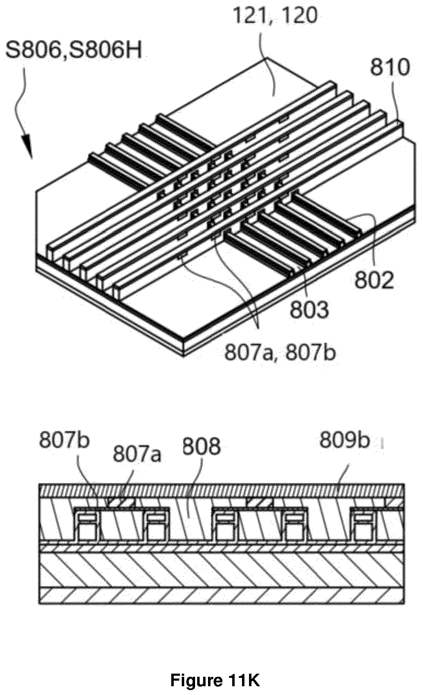

En référence à la figure 10, l'étape S806 comporte préférentiellement les sous-étapes successives S806A, S806B, S806C, S806D, S806E, S806F, S806G et S806H illustrées respectivement sur les figures 11D, 11E, 11F, 11G, 11H, 11I, 11J, et 11K.

En référence à la figure 11D, la sous-étape S806A consiste à former des bandes conductrices inférieures 805 en remplissant les espaces inter-premières bandes 803 du matériau conducteur destiné à former les deuxièmes grilles 132 Le remplissage est réalisé jusqu'à hauteur de la couche d'encapsulation 8041 disposée sur la face supérieure des premières bandes 802. Ce remplissage est avantageusement suivi d'une planarisation de la couche conductrice déposée pour laisser une surface supérieure 805a plane au ras des premières bandes 802.

En référence à la figure 11E, la sous-étape S806B consiste à déposer, sur toute la surface supérieure 805a formée à l'issue de l'étape S806A, un empilement 806 de couches barrière comprenant : une couche barrière inférieure 8061 formée avec le matériau de la couche tunnel 1441 et une couche barrière supérieure 8062 formée avec le matériau des motifs barrières 1442.

La sous-étape S806C qui prolonge la sous-étape S806B consiste à structurer en trois dimensions l'empilement de couches diélectriques 806 pour former des bandes barrières 807. En référence à la figure 11F, ces bandes barrière 807 sont préférentiellement parallèles les unes aux autres et orientées à 45° par rapport aux premières bandes 801. En outre, dans une direction X₁ perpendiculaire aux premières bandes 802. En outre, chaque bande barrière 807 recouvre une bande conductrice inférieure 803 ainsi que les deux premières bandes 801 adjacentes.

L'orientation des bandes barrière 807 permet de réaliser la périodicité souhaitée des détecteurs de charge 140 dans le dispositif quantique 100. Ici, l'orientation à 45° permet de réaliser la périodicité d'un ilot 141 formé dans une région conductrice inférieure 1361 sur deux (c'est-à-dire de un détecteur de charge 140 pour deux boites quantiques 1151).

La structure résultante est illustrée en figure 11F.

Ces bandes barrières 807 définissent la couche tunnel 1441 et permettent de définir les ilots 141.

La sous-étape S806D suivante consiste à réaliser une gravure anisotrope de la couche barrière supérieure 8062 à partir des bandes barrières 807, et avec arrêt sur la couche barrière inférieure 8061. La structure finale est illustrée en figure 11G. Dans chaque bande diélectrique 807 ainsi structurée, la couche barrière supérieure 8062 forme une bande diélectrique supérieure 807a dont les dimensions latérales (selon la direction X) sont inférieures à la dimension de la bande conductrice inférieure 805c, et qui est positionnée dans une zone centrale 8051 de cette bande conductrice inférieure 805c. La quatrième couche diélectrique 8061 forme une bande barrière inférieure 707b.

La sous-étape S806E, illustrée en figure 11H consiste à former une couche conductrice supérieure 808 en déposant le matériau conducteur destiné à former les deuxièmes grilles 132 sur la totalité des bandes diélectriques inférieures et supérieures 807a, 807b et jusqu'au ras de ces bandes diélectriques supérieures 807a. Cette sous-étape S806E peut en outre comprendre une opération de planarisation de la couche conductrice supérieure 808.

Les sous-étapes S806F, S806G et S806H visent à structurer en trois dimensions l'empilement 808a formé par les bandes conductrices inférieures 805 et la couche conductrice supérieure 808 pour former des deuxièmes bandes conductrices 809 parallèles les unes aux autres et orientées perpendiculairement aux premières bandes 802, s'étendant sur la couche 120 de diélectrique et croisant les premières bandes en formant des ponts isolants par-dessus ces premières bandes 802.

La sous-étape S806F, illustrée en figure 11I consiste à former une ou plusieurs couches 809a, 809b destinées à former un masque dur 809 sur toute la surface planarisée.

La sous-étape S806G, illustrée en figure 11J, consiste définir un masque de gravure dans la couche de masque dur 809, de manière à définir des deuxièmes bandes 810 parallèles les unes aux autres et orientées perpendiculairement par rapport aux premières bandes 802, s'étendant en regard des deuxièmes barrières tunnel 1152b (non représentées sur la figure 11J), et enrobant chacune une pluralité de portions des couches barrières 807a, 807b.

La sous-étape S806H, consiste à réaliser une gravure sélective à travers le masque dur 809, des bandes diélectriques structurées 807a et 807b, de la bande conductrice supérieure 808 et des bandes conductrices inférieures 805, avec arrêt sur la couche 120 de diélectrique.

La structure ainsi formée est illustrée en figure 11K.

A l'issue de cette sous-étape S806H, les deuxièmes bandes 810 sont formées. Ces deuxièmes bandes 810 correspondent aux deuxièmes grilles avec les détecteurs de charge 140 formés en leur sein.

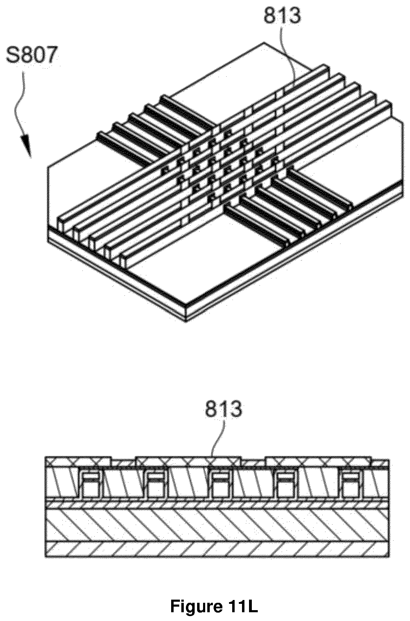

Le procédé de fabrication peut en outre se poursuivre avec une étape S807 consistant à retirer le masque dur 809 resté sur la face supérieure des deuxièmes bandes 810, puis à réaliser une siliciuration, par exemple par dépôt d'une couche 813 de SiN sur les deuxièmes bandes 810. La figure 11L illustre le dispositif quantique 100 obtenu à l'issue de cette étape S807.

Le procédé de fabrication qui vient d'être décrit permet de fabriquer le dispositif quantique 100 selon le premier mode de réalisation (cf. figure 1).

Pour réaliser le dispositif quantique 100 selon le deuxième mode de réalisation (cf. figure 7), les étapes sont identiques à l'exception de :

La sous-étape S806C de structuration des bandes diélectriques 807 qui est modifiée de sorte que seule la couche diélectrique supérieure 8062 soit structurée, et de sorte que la structure résultante définisse des bandes diélectriques qui s'étendent non pas à 45°par rapport aux premières bandes, mais à 90°. De la sorte, les bandes diélectriques définissent un ilot dans chaque bande conductrice inférieure,

La sous-étape S806D est supprimée.

Cette manière de réaliser la structuration des bandes diélectriques est avantageuse en ce qu'elle réduit le nombre d'étapes à réaliser.

## Revendications

1. Dispositif quantique (100) comprenant :
- Une couche semiconductrice (110) adaptée pour former une matrice bidimensionnelle (115) de boites quantiques (1151), la couche semiconductrice (110) présentant une face avant (110a),
- un diélectrique (121), disposé sur la face avant (110a) de la couche semiconductrice (110),
- Des premières lignes de grilles (131) et des deuxièmes lignes de grilles (132) pour contrôler les boîtes quantiques (1151), les premières lignes de grilles (131) et les deuxièmes lignes de grilles (132) s'étendant directement sur le diélectrique (121), chaque deuxième ligne de grilles (132) croisant les premières lignes de grilles (131), les premières et deuxièmes lignes de grilles (131, 132) définissant un réseau de mailles bidimensionnelles, chaque maille bidimensionnelle étant en regard d'une boite quantique (1151), les premières et deuxièmes lignes de grilles étant des lignes de grilles de couplage,
- Des détecteurs de charges (140), chaque détecteur de charge (140) comprenant un réservoir de charge (142) conducteur et un ilot conducteur (141),
l'ilot conducteur (141) de chaque détecteur de charge (140) étant formé au niveau d'une maille bidimensionnelle, entre deux premières lignes de grilles (131) adjacentes et directement sur le diélectrique (121).

2. Dispositif quantique (100) selon la revendication 1, dans lequel chaque détecteur de charge (140) comprend un contact de ligne de grilles (144), ledit contact de ligne de grilles étant formé par une couche barrière (1441,1442) de charges recouvrant l'îlot conducteur (141) correspondant au détecteur de charge (140).

3. Dispositif quantique (100) selon l'une des revendications 1 à 2, dans lequel l'ilot conducteur (141) de chaque détecteur de charge (140) est formé dans une ligne de grilles (132, 135) de contrôle des boites quantiques (1151) distincte des premières lignes de grilles (131), ladite ligne de grilles (132, 135) croisant les premières lignes de grilles (131) et s'étendant directement sur le diélectrique (121), ladite ligne de grilles (132, 135) présentant des renfoncements (133_{R}) recouverts d'une couche électriquement isolante, les renfoncements (133_{R}) isolants étant disposés aux croisements (I_{G1,G2}, I_{G1,G3}) de ladite ligne de grilles (132, 135) avec les premières lignes de grilles (131), chaque renfoncement (133_{R}) isolant abritant une première ligne de grilles (131), les renfoncements (133_{R}) isolants définissant, dans ladite ligne de grilles (132,135), une pluralité de régions conductrices inférieures (1361) s'étendant directement sur le diélectrique (121), et une région conductrice supérieure (137) continue.

4. Dispositif quantique (100) selon la revendication 3, dans lequel ladite ligne de grilles est l'une des deuxièmes lignes de grilles (132).

5. Dispositif quantique (100) selon la revendication 3, dans lequel ladite ligne de grilles est une troisième ligne de grilles (135) d'un ensemble de troisièmes lignes de grilles (135) destinées à contrôler le potentiel chimique des boites quantiques (1151), chaque troisième ligne de grilles (135) étant disposée à l'aplomb des boites quantiques (1151) formées le long d'une colonne (115b) ou d'une diagonale (115c) de matrice (115) de boites quantiques.

6. Dispositif quantique (100) selon l'une des revendications 3 à 5, dans lequel ladite ligne de grilles présente une structure interne d'un premier type comprenant :
- une région conductrice inférieure (1361-1) sur deux prolongeant la région conductrice supérieure (137) vers le diélectrique (120) et définissant une région conductrice inférieure complémentaire (1361-2),
- la région conductrice inférieure complémentaire (1361-2) recouverte d'une couche barrière inférieure, appelée couche tunnel (1141), la couche tunnel (1441) étant disposée sur les renfoncements (133_{R}) isolants adjacents à la région conductrice inférieure complémentaire (1361-2),
- un motif diélectrique (1142) formant une couche barrière supérieure (1142) s'étendant à travers la région conductrice supérieure (137) de la couche tunnel (1141) jusqu'à la face supérieure de ladite ligne de grilles, le motif diélectrique étant enrobé par la région conductrice supérieure (137) et disposé à l'aplomb d'une partie au moins de la région conductrice inférieure complémentaire (1361-2).

7. Dispositif quantique (100) selon l'une des revendications 3 à 5, dans lequel la structure interne de ladite deuxième ligne de grilles est d'un deuxième type dans lequel :
- Toutes les régions conductrices inférieures (1361) de ladite ligne de grilles sont recouvertes d'une couche tunnel (1441), la couche tunnel (1441) étant continue et disposée sur les renfoncements (133_{R}) de ladite ligne de grilles,
- Chaque région conductrice inférieure est surmontée d'un motif diélectrique (1442), chaque motif diélectrique formant avec la couche tunnel (1141) une couche barrière (144), chaque motif diélectrique traversant la région conductrice supérieure (137) de la couche tunnel (1441) disposée sur la région conductrice inférieure associée jusqu'à la face supérieure de ladite ligne de grilles, le motif diélectrique étant enrobé par la région conductrice supérieure (137) et disposé à l'aplomb d'une partie au moins de la région conductrice inférieure associée (1361-2).

8. Dispositif quantique (100) selon les revendications 3 à 7, comprenant des lignes de métallisation (1445), dites lignes de lecture (1145) des détecteurs de charge (140), chaque ligne de lecture (1445) étant couplée, d'une part à la région conductrice supérieure (137) d'une ligne de grilles (132, 135) formant des ilots conducteurs, et d'autre part à un circuit de lecture (1446), ledit circuit de lecture (1446) comprenant une inductance et une capacité formant un circuit résonant dont la fréquence de résonance dépend de l'impédance des détecteurs de charge (140), permettant des mesures en réflectométrie.

9. Dispositif quantique (100) selon les revendications 1 à 8, dans lequel la couche semiconductrice (110) comprend des trous (117) pour former les boites quantiques (1151).

10. Dispositif quantique (100) selon l'une des revendications 1 à 9, dans lequel l'ilot (141) de chaque détecteur de charges (140) est situé dans un même plan horizontal que les premières lignes de grilles (131), et le réservoir de charges (142) de chaque détecteur de charges (140) est situé dans un même plan horizontal qu'une région conductrice supérieure (137) des deuxièmes lignes de grilles (131).

11. Procédé de fabrication (8) d'un dispositif quantique (100) comprenant des détecteurs de charge (140), chaque détecteur de charge (140) comprenant un îlot conducteur (141) et un réservoir de charge (142), le procédé (8) comprenant les étapes suivantes :
- Fourniture (S801, S810) d'une couche semiconductrice adaptée pour former une matrice bidimensionnelle (115) de boites quantiques (1151), ladite couche semiconductrice (110) présentant une face avant (110a), ladite couche semiconductrice (110) comprenant un diélectrique (121) disposé sur la face avant (110a) et des premières lignes de grilles (131) pour contrôler les boites quantiques (1151), les premières lignes de grilles (131) s'étendant directement sur le diélectrique (121), les premières lignes de grilles (131) étant des lignes de grilles de couplage,
- Enrobage (S815) des flancs et de la face supérieure de chaque première ligne de grilles (131) pour loger chaque première ligne de grilles (131) sous un renfoncement isolant (133_{R}),
- Définition (S820A, S820B, S820C) des îlots conducteurs (141) à partir des premières lignes de grilles enrobées, chaque ilot conducteur (141) s'étendant entre deux premières lignes de grilles (131) adjacentes et directement sur le diélectrique (121),
- Formation (S820D), à partir des îlots conducteurs (141) définis, de deuxièmes lignes de grilles (132) pour contrôler, avec les premières lignes de grilles, les boites quantiques, chaque deuxième ligne de grilles s'étendant directement sur le diélectrique (121) et croisant les premières lignes de grilles (131), les premières et deuxièmes lignes de grilles (131, 132) formant un réseau de mailles bidimensionnelles sur le diélectrique (121), les deuxièmes lignes de grilles (132) étant des lignes de grilles de couplage.

12. Procédé de fabrication selon la revendication 11, dans lequel l'étape (S820A, S820B, S820C) de définition des îlots conducteurs comprend les sous-étapes suivantes :
- Remplissage (S820A) avec un matériau conducteur des espaces (803) du diélectrique (121) délimités par deux premières lignes de grilles adjacentes enrobées (802), le remplissage s'arrêtant à la hauteur des renfoncements isolants,
- Formation (S820B) d'une couche barrière (806) sur toute la surface obtenue après le remplissage,
- Structuration (S820C) de la couche barrière (806) pour former des bandes barrières (807) orientées avec un angle prédéterminé par rapport aux premières lignes de grilles.

13. Procédé de fabrication (8) selon l'une des revendication 11 à 12, dans lequel l'angle prédéterminé est tel que les bandes barrières (807) sont orientées à 45° par rapport à la direction des premières lignes de grilles, les bandes barrières s'étendant, dans la direction perpendiculaire aux premières lignes de grilles, sur quatre bandes conductrices adjacentes.
